Europäisches Patentamt

European Patent Office

Office européen des brevets

(19)

(11) Veröffentlichungsnummer: **0 106 951**
**B1**

(12) # EUROPÄISCHE PATENTSCHRIFT

(45) Veröffentlichungstag der Patentschrift:
**12.06.85**

(21) Anmeldenummer: **83107584.1**

(22) Anmeldetag: **02.08.83**

(51) Int. Cl.⁴: **G 01 R 23/167**, G 05 B 5/01,
G 01 D 5/34

(54) **Positionsmessverfahren und Einrichtungen zur Durchführung des Verfahrens.**

(30) Priorität: **22.10.82 DE 3239108**

(43) Veröffentlichungstag der Anmeldung:
**02.05.84 Patentblatt 84/18**

(45) Bekanntmachung des Hinweises auf die Patenterteilung:
**12.06.85 Patentblatt 85/24**

(84) Benannte Vertragsstaaten:
**AT CH DE FR GB IT LI NL SE**

(56) Entgegenhaltungen:
**DE - A - 2 729 697
DE - C - 1 941 731
GB - A - 1 463 142
GB - A - 2 043 269**

(73) Patentinhaber: **Dr. Johannes Heidenhain GmbH,
Nansenstrasse 17, D-8225 Traunreut (DE)**

(72) Erfinder: **Spies, Alfons, Dipl.-Ing., Wopfnerstrasse 2,
D-8221 Seebruck (DE)**

ACTORUM AG

## Beschreibung

Die Erfindung betrifft ein Verfahren zur Gewinnung oberwellenfreier periodischer Signale bei einer inkrementalen oder absoluten Messeinrichtung.

Zur Messung der Relativlage zweier Objekte, beispielsweise der Relativlage eines Schlittens bezüglich des Betts einer Werkzeugmaschine, ist es bekannt, photoelektrische, magnetische, induktive oder kapazitive Messeinrichtungen einzusetzen.

Bei einer photoelektrischen Längenmesseinrichtung wird die Teilung eines Teilungsträgers (Massstab), der mit dem einen Objekt verbunden ist, von einer Abtasteinheit abgetastet, die mit dem anderen Objekt verbunden ist. Die Abtasteinheit weist zu diesem Zweck eine Beleuchtungseinrichtung, eine Abtastplatte mit beispielsweise zwei Teilungsfeldern, deren Teilungen um 90° gegeneinander phasenversetzt sind und mit der Teilung des Teilungsträgers exakt übereinstimmen, sowie zwei Photoelemente auf, die jeweils einem Teilungsfeld zugeordnet sind. Die gleichartigen Teilungen der Abtastplatte und des Teilungsträgers bestehen beim Durchlichtmessverfahren aus lichtdurchlässigen und lichtundurchlässigen Streifen, die in Längserstreckung des Teilungsträgers (Messrichtung) alternierend aufeinander folgen. Der Lichtstrom der Beleuchtungseinrichtung, der die Teilungen des Teilungsträgers und der Abtastplatte durchsetzt und anschliessend auf die beiden Photoelemente fällt, wird bei der Relativbewegung der beiden Objekte an den Teilungen moduliert, so dass die beiden, jeweils einem Teilungsfeld zugeordneten Photoelemente zwei periodische elektrische Analogsignale liefern, die um 90° gegeneinander phasenversetzt sind. Diese sinusförmigen elektrischen Analogsignale werden einer Auswerteeinrichtung zur Bildung von Positionsmesswerten zugeführt.

Die Periode der gewonnenen Analogsignale wird durch die Teilungsperiode oder das Inkrement der Teilung des Teilungsträgers bestimmt. Das Inkrement wird durch die Breiten eines lichtdurchlässigen und eines lichtundurchlässigen Streifens in Messrichtung gebildet. Bei der Relativbewegung zwischen der Abtasteinheit und der Teilung des Teilungsträgers wird jedes abgetastete Inkrement durch einen Zählimpuls erfasst und angezeigt.

Die aus den Teilungen der Teilungsträger bei photoelektrischen, magnetischen, induktiven und kapazitiven Messeinrichtungen gewonnenen periodischen Analogsignale weisen im allgemeinen keinen reinen sinusförmigen Verlauf auf, sondern sind beispielsweise infolge von Ungenauigkeiten der Teilungen oberwellenbehaftet. Diese Ungenauigkeiten der Teilungen werden z.B. durch unterschiedliche Abstände der lichtdurchlässigen und lichtundurchlässigen Streifen oder durch eine Kantenunschärfe dieser Streifen hervorgerufen. Um die gewonnenen Analogsignale weitgehend oberwellenfrei zu halten, müssen hohe Anforderungen an die Genauigkeit der Teilungen gestellt werden. Zur Bildung von genauen Positionsmesswerten für jede Teilungsperiode und um zur weiteren Erhöhung der Messgenauigkeit die Teilungsperioden der Teilung durch Bildung von Interpolationswerten exakt unterteilen zu können, muss das aus dieser Teilung gewonnene Analogsignal oberwellenfrei sein; eine Bildung von Interpolationswerten beispielsweise mittels eines Rechners ist in der DE-A1 Nr. 2729697 beschrieben.

Weiterhin sind Messeinrichtungen bekannt, die dreieckförmige oder trapezförmige Analogsignale liefern, die naturgemäss stets oberwellenbehaftet sind.

Aus der DE-C Nr. 1941731 ist eine photoelektrische Längenmesseinrichtung bekannt, bei der zur Gewinnung eines oberwellenfreien Analogsignals bei der Abtastung der Teilung eines Teilungsträgers eine Frequenzfilterblende mit einem sinusförmigen Durchlässigkeitsverlauf vorgesehen ist. Bei dieser Messeinrichtung muss eine spezielle Frequenzfilterblende hergestellt und eingebaut werden. Zudem ist diese Messeinrichtung auf das photoelektrische Durchlichtmessprinzip beschränkt.

Der Erfindung liegt die Aufgabe zugrunde, ein Verfahren zur Gewinnung oberwellenfreier periodischer Signale bei einer inkrementalen Messeinrichtung anzugeben, die zu diesem Zweck keiner speziellen Elemente bedarf und universell einsetzbar ist.

Diese Aufgabe wird erfindungsgemäss durch die kennzeichnenden Massnahmen der Ansprüche 1 und 4 gelöst.

Die mit der Erfindung erzielten Vorteile bestehen insbesondere darin, dass auf einfache Weise die Gewinnung oberwellenfreier periodischer Signale lediglich mit den herkömmlichen Mitteln bekannter Positionsmesseinrichtungen ermöglicht wird, ohne dass zusätzliche Elemente wie Frequenzfilterblenden erforderlich sind und ohne dass besondere Anforderungen an die Genauigkeit der Teilung gestellt werden müssen. Es ergibt sich somit eine preiswerte, konventionell aufgebaute Messeinrichtung; darüber hinaus wird die Lagerhaltung vereinfacht.

Vorteilhafte Weiterbildungen der Erfindung entnimmt man den abhängigen Ansprüchen.

Ausführungsbeispiele der Erfindung werden anhand der Zeichnung näher erläutert. Es zeigen:

Fig. 1 eine Längenmesseinrichtung im Querschnitt,

Fig. 2 schematisch eine Abtasteinheit der Längenmesseinrichtung,

Fig. 3 eine Anordnung von Abtastelementen,

Fig. 4 eine weitere Anordnung von Abtastelementen,

Fig. 5 eine digitale Auswerteschaltung, und

Fig. 6 und 7 analoge Auswerteschaltungen.

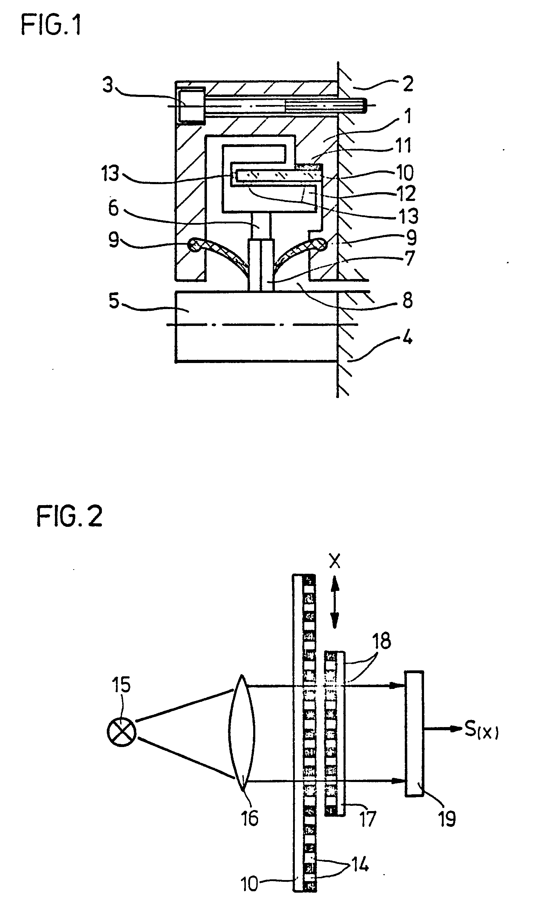

In Fig. 1 ist eine Längenmesseinrichtung im Querschnitt dargestellt, deren Gehäuse 1 in Form eines Hohlprofils an einem Bett 2 einer nicht dargestellten Bearbeitungsmaschine mittels einer Schraubverbindung 3 befestigt ist. An einem Schlitten 4 der Bearbeitungsmaschine ist ein Montagefuss 5 mit einem Mitnehmer 6 in beliebiger Weise befestigt, der über eine schwertförmige Verjüngung 7 durch einen Schlitz 8 in das im übrigen vollkommen geschlossene Gehäuse 1 hineinragt, wobei im Schlitz 8 vorgesehene elastische Dichtlippen 9 ein Eindringen von Verunreinigungen in das Innere des Gehäuses 1 verhindern. An einer Innenfläche des Gehäuses 1 ist ein Massstab 10 mittels einer elastischen Klebeschicht 11 angebracht, an dem sich eine Abtasteinheit 12 über Rollen 13 abstützt; die Relativbewegung des Schlittens 4 bezüglich des Betts 2 wird vom Mitnehmer 6 auf die Abtasteinheit 12 übertragen.

Gemäss Fig. 2 sind zur Abtastung der Teilung 14 des Massstabs 10 in der Abtasteinheit 12 eine Lichtquelle 15, ein Kondensor 16, eine Abtastplatte 17 mit einer Teilung 18 und ein Photoelement 19 angeordnet. Die Teilung 18 der Abtastplatte 17 ist mit der Teilung 14 des Massstabs 10 identisch. Der von der Lichtquelle 15 ausgehende Lichtstrom wird vom Kondensor 16 parallel gerichtet, durchsetzt die Teilungen 14, 18 des Massstabs 10 und der Abtastplatte 17 und fällt anschliessend auf das Photoelement 19. Bei der Bewegung der Abtasteinheit 12 mit der Abtastplatte 17 in Messrichtung x gegenüber dem feststehenden Masstab 10 wird der Lichtstrom an den Teilungen 14, 18 moduliert, so dass das Photoelement 19 ein periodisches elektrisches Analogsignal S (x) liefert, das ausgewertet, gezählt und in digitaler Form als Positionsmesswert zur Anzeige gebracht wird.

Das vom Photoelement 19 gelieferte periodische Analogsignal S (x) ist im allgemeinen z.B. aufgrund von Ungenauigkeiten der Teilungen 14, 18 oberwellenbehaftet und kann als Funktion des Messweges x durch eine Fourierreihe dargestellt werden:

$$S(x) = a_o/2 + \sum_{k=1}^{N} (a_k \cos kx + b_k \sin kx)$$

Der laufende Summationsindex k ist die Ordnungszahl der Wellen oder Frequenzen (Grundwelle: k=1; 1. Oberwelle: k=2 usw.) und $a_k$, $b_k$ sind die Fourierkoeffizienten.

Zur Gewinnung oberwellenfreier periodischer Signale wird erfindungsgemäss vorgeschlagen, die Bandbreite N (Anzahl der Frequenzen oder Wellen) des Analogsignals S (x) zu ermitteln, die Teilungsperiode P der Teilung 14 jeweils mit mindestens 2N Abtastelementen $T_1$-$T_{2N}$ abzutasten, die von den Abtastelementen $T_1$-$T_{2N}$ gelieferten periodischen Analogsignale $S_1$-$S_{2N}$ zur Ermittlung der Fourierkoeffizienten $a_1$, $b_1$; $U_a$, $U_b$ der Grundwelle des Analogsignals S (x) einer Fourieranalyse zu unterziehen und die Fourierkoeffizienten $a_1$, $b_1$; $U_a$, $U_b$ als oberwellenfreie periodische Signale zur Bildung von Positionsmesswerten auszuwerten.

Zur Ermittlung der für die Teilung 14 typischen Bandbreite N (Anzahl der Wellen mit nicht verschwindenden Fourierkoeffizienten $a_k$, $b_k$) des Analogsignals S (x) wird die Teilung 14 beispielsweise durch ein Abtastelement unter Bezugnahme auf ein Referenzmesssystem abgetastet und das gewonnene Analogsignal S (x) einer rechnerischen Fourieranalyse unterzogen. Die Bandbreite N braucht bei einer Serie von identischen Teilungen nur einmal ermittelt zu werden.

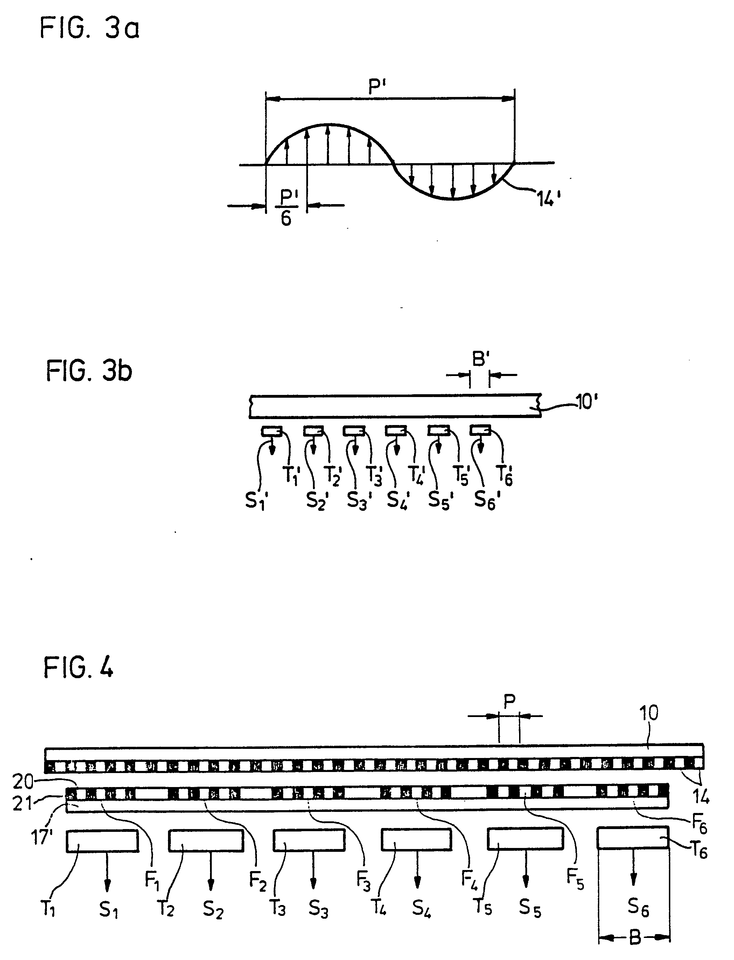

In Fig. 3b ist ein Massstab 10' aus einem magnetisierbaren Material gezeigt, der eine magnetische Teilung 14' mit einer Teilungsperiode P' gemäss Fig. 3a aufweist. Das aus der Teilung 14' gewonnene Analogsignal S' habe die Bandbreite N=3. Erfindungsgemäss sind daher sechs äquidistante Abtastelemente $T_1'$-$T_6'$ der Teilungsperiode P' zugeordnet. Die Abtastelemente $T_1'$-$T_6'$ in Form schematisch dargestellter Halbelemente liefern bei der Abtastung der Teilung 14' periodische Analogsignale $S_1'$-$S_6'$, die einer Fourieranalyse unterzogen werden. Die Abtastelemente $T_1'$-$T_6'$ sind in einem Abstand P'/6+zP' (z=0, 1, 2, ...) zueinander angeordnet, wobei jedes Abtastelement $T_1'$-$T_6'$ eine Breite B' kleiner P'/6 aufweist.

In Fig. 4 ist der Massstab 10 gemäss der Fig. 2 dargestellt, der die Teilung 14 mit der Teilungsperiode P aufweist. Das aus der Teilung 14 gewonnene Analogsignal S habe die Bandbreite N=3. Erfindungsgemäss sind daher sechs Abtastelemente $T_1$-$T_6$ in der Abtasteinheit 12 in den Abständen B+zP+P/6 (z=0, 1, 2, ...) in Messrichtung x zueinander angeordnet, da die Breite B der Abtastelemente $T_1$-$T_6$ grösser ist als die Teilungsperiode P. Den Abtastelementen $T_1$-$T_6$ in Form von Photoelementen sind jeweils Teilungsfelder $F_1$-$F_6$ auf der Abtastplatte 17' zugeordnet, die ebenfalls in den Abständen B+zP+P/6 zueinander angeordnet sind. Die bei der Abtastung der Teilung 14 von den Abtastelementen $T_1$-$T_6$ gelieferten Analogsignale $S_1$-$S_6$ werden einer Fourieranalyse unterzogen. Die Teilungen der Teilungsfelder $F_1$-$F_6$ weisen die Teilungsperiode P auf und bestehen abwechselnd aus lichtdurchlässigen aktiven Streifen 20 (Zonen) und aus lichtundurchlässigen passiven Streifen 21 (Zonen) der Breite P/2.

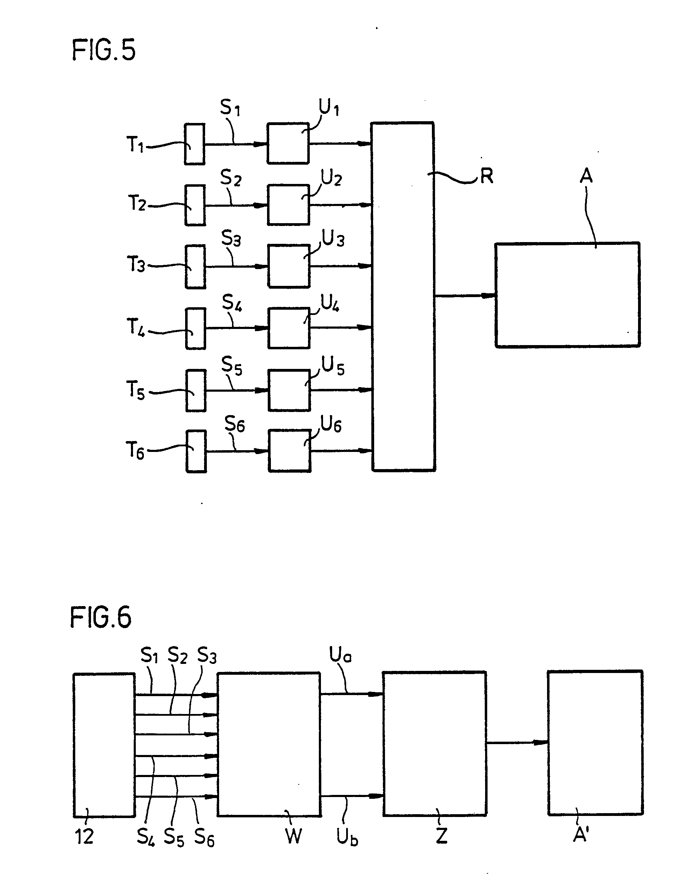

Zur digitalen Auswertung werden gemäss Fig. 5 die Analogsignale $S_1$-$S_6$ der Abtastelemente $T_1$-$T_6$ mittels Analog-/Digital-Umsetzer $U_1$-$U_6$ digitalisiert und einem Digitalrechner R zugeführt, der die Fourierkoeffizienten $a_1$, $b_1$ der Grundwelle (k=1) als oberwellenfreie periodische Signale ermittelt:

$$a_1 = 1/N \sum_{n=1}^{2N} S_n \cos \pi (n-1)/N$$
$$= 1/3 \sum_{n=1}^{6} S_n \cos \pi (n-1)/3$$
$$b_1 = 1/N \sum_{n=1}^{2N} S_n \sin \pi (n-1)/N$$
$$= 1/3 \sum_{n=1}^{6} S_n \sin \pi (n-1)/3$$

Der Rechner ermittelt so dann den Phasenwinkel $\varphi = \arctan a_1/b_1$, der ein Mass für die absolute Lage der Abtasteinheit 12 innerhalb einer Teilungsperiode P der Teilung 14 darstellt. Aus dem Phasenwinkel $\varphi$ werden die absoluten Positionsmesswerte $x = \varphi \cdot P/2\pi$ der Abtasteinheit 12 innerhalb einer Teilungsperiode P berechnet und einer Steuer- und/oder Anzeigeeinheit A zur Steuerung einer Maschine und/oder zur digitalen Anzeige zugeführt. Bewegt sich die Abtasteinheit 12 über mehrere Teilungsperioden P, so ermittelt der Rechner, ob der Phasenwinkel $\varphi$ von $2\pi$ auf 0 oder von 0 auf $2\pi$ springt. Der Zählerstand in der Einheit A wird bei einem solchen Sprung jeweils um die Einheit der Teilungsperiode P erhöht oder erniedrigt, so dass eine lückenlose Ermittlung der Relativlage der beiden Objekte 2, 4 ermöglicht wird.

Zur analogen Auswertung werden gemäss Fig. 6 die periodischen Analogsignale $S_1$-$S_6$ der Abtastelemente $T_1$-$T_6$ der Abtasteinheit 12 einer Auswerteinrichtung W zur Ermittlung der Fourierkoeffizienten $U_a$, $U_b$ zugeführt, die anschliessend einer Auswerteeinrichtung Z zur Bildung von Positionsmesswerten zugeleitet werden. Diese Auswerteeinrichtung Z besteht aus einem Richtungsdiskriminator zur Ermittlung der Messrichtung und aus einem Vorwärts-/Rückwärts-Zähler, der die vom Richtungsdiskriminator abgegebenen Impulse vorzeichenrichtig zählt. Die Auswerteschaltung Z, die an eine Steuer- und/oder Anzeigeeinheit A' angeschlossen ist, kann eine Interpolationseinrichtung zur Bildung von Interpolationswerten innerhalb einer Signalperiode P der Teilung 14 aufweisen, wie sie beispielsweise in der DE-OS Nr. 2729697 beschrieben ist; eine Interpolation kann auch durch die Ermittlung des Phasenwinkels $\varphi = \arctan U_a/U_b$ innerhalb einer Teilungsperiode P der Teilung 14 mittels eines Unterteilungsnetzwerkes erfolgen (wie oben beschrieben).

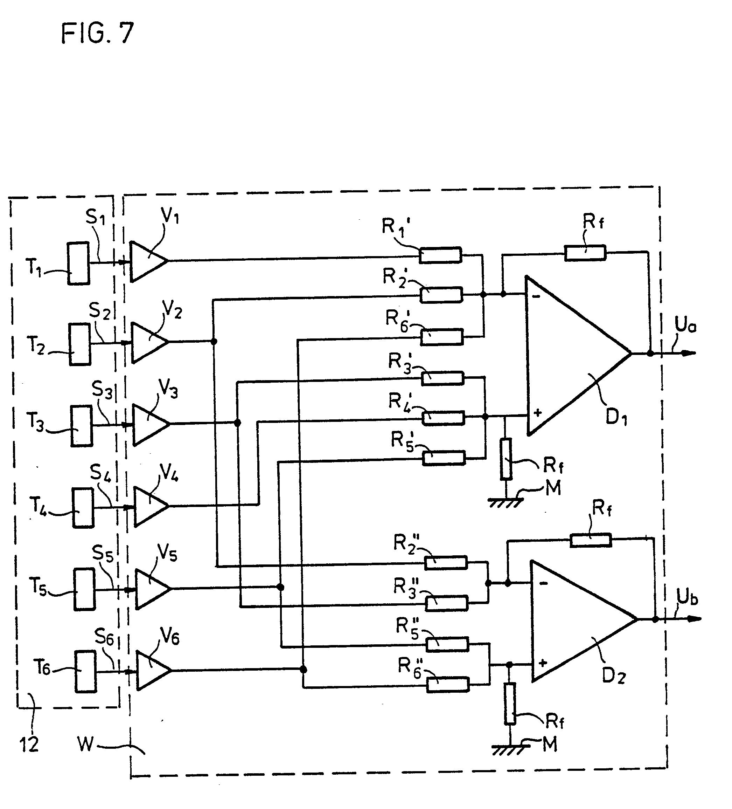

In der Auswerteeinrichtung W gemäss Fig. 7 werden die Analogsignale $S_1$-$S_6$ der Abtastelemente $T_1$-$T_6$ in der Abtasteinheit 12 über Verstärker $V_1$-$V_6$ und Widerstände $R_1'$-$R_6'$, $R_2''$, $R_3''$, $R_5''$, $R_6''$ den beiden Eingängen zweier Differenzverstärker $D_1$, $D_2$ zugeleitet. Über gleich grosse Widerstände $R_f$ sind die Ausgänge der Differenzverstärker $D_1$, $D_2$ mit ihren invertierenden Eingängen rückgekoppelt und die nichtinvertierenden Eingänge der Differenzverstärker $D_1$, $D_2$ mit Masse M verbunden. Die verstärkten Analogsignale $S_1$, $S_2$, $S_6$ gelangen jeweils über die Widerstände $R_1'$, $R_2'$, $R_6'$ an den invertierenden Eingang des Differenzverstärkers $D_1$, die verstärkten Analogsignale $S_3$, $S_4$, $S_5$ über die Widerstände $R_3'$, $R_4'$, $R_5'$ an den nichtinvertierenden Eingang des Differenzverstärkers $D_1$, die verstärkten Analogsignale $S_2$, $S_3$ über die Widerstände $R_2''$, $R_3''$ an den invertierenden Eingang des Differenzverstärkers $D_2$ und die verstärkten Analogsignale $S_5$, $S_6$ über die Widerstände $R_5''$, $R_6''$ an den nichtinvertierenden Eingang des Differenzverstärkers $D_2$.

Die Widerstände $R_n'$, $R_n''$ bewirken in Verbindung mit den Widerständen $R_f$ eine Multiplikation der Analogsignale $S_n$ mit den Faktoren $\cos \pi (n-1)/3$ und $\sin \pi (n-1)/3$. Die Bemessung der Widerstandsverhältnisse $R_f/R_n'$ und $R_f/R_n''$ für die Analogsignale $S_n$ ist in der Tabelle dargestellt.

| $S_n$ | $\cos \pi$ $(n-1)/3$ | $R_f/R_n'$ | $\sin \pi$ $(n-1)/3$ | $R_f/R_n''$ |
|---|---|---|---|---|
| $S_1$ | 1 | 1 | 0 | 0 |
| $S_2$ | 0,5 | 0,5 | 0,87 | 0,87 |
| $S_3$ | −0,5 | 0,5 | 0,87 | 0,87 |
| $S_4$ | −1 | 1 | 0 | 0 |
| $S_5$ | −0,5 | 0,5 | −0,87 | 0,87 |
| $S_6$ | 0,5 | 0,5 | −0,87 | 0,87 |

Die den negativen cos- und sin-Faktoren entsprechenden Widerstände $R_n$ sind an die nichtinvertierenden Eingänge der Differenzverstärker $D_1$, $D_2$ angeschlossen. Der Differenzverstärker $D_1$ summiert die Werte $S_n \cos \pi (n-1)/3$ und der Differenzverstärker $D_2$ die Werte $S_n \cdot \sin \pi (n-1)/3$ auf, so dass am Ausgang des Differenzverstärkers $D_1$ das oberwellenfreie periodische Analogsignal $U_a$:

$$U_a = \sum_{n=1}^{6} S_n \cos \pi (n-1)/3$$

und am Ausgang des Differenzverstärkers $D_2$ das oberwellenfreie periodische Analogsignal $U_b$:

$$U_b = \sum_{n=1}^{6} S_n \sin \pi (n-1)/3$$

anstehen.

Auf die gleiche vorbeschriebene Weise werden auch die Analogsignale $S_n'$ gemäss Fig. 3 ausgewertet.

Das vorgeschlagene Verfahren ist auch bei induktiven und kapazitiven Messeinrichtungen sowie zur Abtastung inkrementaler Spuren, beispielsweise der feinsten inkrementalen Spur von absoluten Messeinrichtungen, einsetzbar.

## Patentansprüche

1. Verfahren zur Gewinnung oberwellenfreier periodischer Signale bei einer inkrementalen oder absoluten Messeinrichtung, dadurch gekennzeichnet, dass die Bandbreite N (Anzahl der Frequenzen oder Wellen) des bei der Abtastung einer Teilung (14) einer Massverkörperung (10) gewonnenen Analogsignals S ermittelt wird, dass die Teilungsperiode P (Inkrement) der Teilung (14) jeweils von mindestens 2N Abtastelementen ($T_1$-$T_{2N}$) abgetastet wird, dass die von den Abtastelementen ($T_1$-$T_{2N}$) gelieferten periodischen Analogsignale ($S_1$-$S_{2N}$) zur Ermittlung der Fourierkoeffizienten $a_1$, $b_1$; $U_a$, $U_b$ der Grundwelle des periodischen Analogsignals S einer Fourieranalyse unterzogen werden, und dass die Fourierkoeffizienten $a_1$, $b_1$; $U_a$, $U_b$ als oberwellenfreie periodische Signale zur Bildung von Positionsmesswerten ausgewertet werden.

2. Verfahren nach Anspruch 1, dadurch gekennzeichnet, dass zur digitalen Auswertung die Analogsignale ($S_1$-$S_{2N}$) der Abtastelemente ($T_1$-$T_{2N}$) digitalisiert werden und rechnerisch die Fourierkoeffizienten $a_1$, $b_1$ als oberwellenfreie periodische Signale und anschliessend die Phasenlage $\varphi = \arctan a_1/b_1$ innerhalb einer Teilungsperiode P der Teilung (14) aus den Fourierkoeffizienten $a_1$, $b_1$ ermittelt werden.

3. Verfahren nach Anspruch 1, dadurch gekennzeichnet, dass zur analogen Auswertung die Analogsignale ($S_1$, ..., $S_n$, ..., $S_{2N}$) mit einem Faktor $\cos \pi (n-1)/N$ multipliziert und zur Bildung eines Analogsignals $U_a$ summiert werden, dass die Analogsignale ($S_1$, ..., $S_n$, ..., $S_{2N}$) mit einem Faktor $\sin \pi (n-1)/N$ multipliziert und zur Bildung eines Analogsignals $U_b$ summiert werden, und dass die Phasenlage $\varphi = \arctan U_a/U_b$ innerhalb einer Teilungsperiode P der Teilung (14) aus den oberwellenfreien periodischen Analogsignalen $U_{\hat{a}}$, $U_b$ ermittelt wird.

4. Einrichtung zur Durchführung des Verfahrens nach Anspruch 1, dadurch gekennzeichnet, dass zur Abtastung der Teilungsperiode P der Teilung (14) in einer Abtasteinheit (12) mindestens doppelt so viele Abtastelemente ($T_1$-$T_{2N}$) vorgesehen sind, wie die Bandbreite N (Anzahl der Wellen oder Frequenzen des Analogsignals S) beträgt, und dass die von den Abtastelementen ($T_1$-$T_{2N}$) gelieferten periodischen Analogsignale ($S_1$-$S_{2N}$) an eine Auswerteeinrichtung (U, R; W, Z) zur Ermittlung der Fourierkoeffizienten $a_1$, $b_1$; $U_a$, $U_b$ der Grundwelle und zur Bildung von Positionsmesswerten aus den Fourierkoeffizienten $a_1$, $b_1$; $U_a$, $U_b$ angelegt sind, die ihrerseits mit einer Steuer- und/oder Anzeigeeinheit (A) verbunden ist.

5. Einrichtung nach Anspruch 4, dadurch gekennzeichnet, dass die Breite B der Abtastelemente ($T_1$-$T_{2N}$) kleiner als P/2N und dass die Abtastelemente ($T_1$-$T_{2N}$) in einem gegenseitigen Abstand P/2N+zP (z=0, 1, 2, ...) in der Abtasteinheit (12) angeordnet sind.

6. Einrichtung nach Anspruch 4, dadurch gekennzeichnet, dass die Breite B der Abtastelemente ($T_1$-$T_{2N}$) wenigstens eine Teilungsperiode P beträgt, dass jedes Abtastelemente ($T_1$-$T_{2N}$) abwechselnd signalaktive Zonen (20) und signalinaktive Zonen (21) aufweist, und dass die Abtastelemente ($T_1$-$T_{2N}$) in einem gegenseitigen Abstand B+zP+P/2N (z=0, 1, 2, ...) in der Abtasteinheit (12) angeordnet sind.

7. Einrichtung nach Anspruch 4, dadurch gekennzeichnet, dass die Auswerteeinrichtung (U, R) mit den periodischen Analogsignalen ($S_1$-$S_{2N}$) beaufschlagte Analog-/Digital-Wandler ($U_1$-$U_{2N}$) und einen diesen nachgeschalteten Rechner (R) aufweist.

8. Einrichtung nach Anspruch 4, dadurch gekennzeichnet, dass die Auswerteeinrichtung (W) zur Ermittlung der Fourierkoeffizienten $U_a$, $U_b$ mit den periodischen Analogsignalen ($S_1$, ..., $S_n$, ..., $S_{2N}$) beaufschlagte Verstärker ($V_1$, ..., $V_n$, ..., $V_{2N}$) aufweist, die über Widerstände ($R_n'$, $R_n''$) an die Eingänge von Differenzverstärkern ($D_1$, $D_2$) angeschlossen sind.

9. Einrichtung nach Anspruch 4, dadurch gekennzeichnet, dass die Auswerteeinrichtung (Z) zur Bildung von Positionsmesswerten einen mit den Fourierkoeffizienten $U_a$, $U_b$ beaufschlagten Richtungsdiskriminator aufweist, der an einen Vorwärts-/Rückwärts-Zähler angeschlossen ist.

10. Einrichtung nach Anspruch 4, dadurch gekennzeichnet, dass die Auswerteeinrichtung (Z) eine Interpolationseinrichtung zur Bildung von Interpolationswerten innerhalb einer Signalperiode P der Teilung (14) aufweist.

## Claims

1. Method for obtaining periodic signals free of harmonics in an incremental or absolute measuring device, characterised in that the bandwidth N (number of frequencies or waves) of the analog signal S obtained during the sampling of a graduation (14) of an embodiment of a measure (10) is determined, in that the graduation period P (increment) of the graduation (14) is in each case sampled by at least 2N sampling elements ($T_1$-$T_{2N}$), in that the periodic analog signals ($S_1$-$S_{2N}$) supplied by the sampling elements ($T_1$-$T_{2N}$) are subjected to a Fourier analysis for determining the Fourier coefficients $a_1$, $b_1$; $U_a$, $U_b$ of the fundamental of the periodic analog signal S, and in that the Fourier coefficients $a_1$, $b_1$; $U_a$, $U_b$ are evaluated as periodic signals free of harmonics for forming position-measuring values.

2. Method according to Claim 1, characterised in that, for the digital evaluation, the analog signals ($S_1$-$S_{2N}$) of the sampling elements ($T_1$-$T_{2N}$) are digitised and, arithmetically, the Fourier coefficients $a_1$, $b_1$ are determined as periodic signals free of harmonics, and then in that the phase relationship $\varphi = \arctan a_1/b_1$ within one graduation period P of the graduation (14) is determined from the Fourier coefficients $a_1$, $b_1$.

3. Method according to Claim 1, characterised in that, for the analog evaluation, the analog signals ($S_1$, ..., $S_n$, ..., $S_{2N}$) are multiplied by a factor $\cos \pi (n-1)/N$ and are summed for forming an analog signal $U_a$, in that the analog signals ($S_1$, ..., $S_n$, ..., $S_{2N}$) are multiplied by a factor $\sin \pi (n-1)/N$ and are summed for forming an analog signal $U_b$, and in that the phase relationship $\varphi = \arctan U_a/U_b$ within one graduation period P of the graduation (14) is determined from the periodic analog signals $U_a$, $U_b$ free of harmonics.

4. Device for carrying out the method according to Claim 1, characterised in that, for sampling the graduation period P of the graduation (14) in one sampling unit (12), at least twice as many sampling elements ($T_1$-$T_{2N}$) as the bandwidth N (number of waves or frequencies of the analog signal S) are provided, and in that the periodic analog signals ($S_1$-$S_{2N}$) supplied by the sampling elements ($T_1$-$T_{2N}$) are applied to an evaluating device (U, R; W, Z) for determining the Fourier coefficients $a_1$, $b_1$; $U_a$, $U_b$ of the fundamental and for forming position-measuring values from the Fourier coefficients $a_1$, $b_1$; $U_a$, $U_b$ which, in turn, is connected to a control and/or display unit (A).

5. Device according to Claim 4, characterised in that the width B of the sampling elements ($T_1$-$T_{2N}$) is smaller than P/2N and in that the sampling elements ($T_1$-$T_{2N}$) are arranged at a mutual distance P/2N + zP (z=0, 1, 2, ...) in the sampling unit (12).

6. Device according to Claim 4, characterised in that the width B of the sampling elements ($T_1$-$T_{2N}$) is at least one graduation period P, in that each sampling element ($T_1$-$T_{2N}$) is provided alternately with signal-active zones (20) and signal-inactive zones (21), and in that the sampling elements ($T_1$-$T_{2N}$) are arranged at a mutual distance B+zP+P/2N (z=0, 1, 2, ...) in the sampling unit (12).

7. Device according to Claim 4, characterised in that the evaluating device (U, R) is provided with analog/digital converters ($U_1$-$U_{2N}$), to which the

periodic analog signals ($S_1$-$S_{2N}$) are applied, which are followed by a computer (R):

8. Device according to Claim 4, characterised in that the evaluating device (W) for determining the Fourier coefficients $U_a$, $U_b$ is provided with amplifiers ($V_1$, ..., $V_n$, ..., $V_{2N}$), to which the periodic analog signals ($S_1$, ..., $S_n$, ..., $S_{2N}$) are applied and which are connected *via* resistors ($R_n'$, $R_n''$) to the inputs of differential amplifiers ($D_1$, $D_2$).

9. Device according to Claim 4, characterised inthat the evaluating device (Z) for forming position-measuring values is provided with a direction discriminator to which the Fourier coefficients $U_a$, $U_b$ are applied and which is connected to an up/down counter.

10. Device according to Claim 4, characterised in that the evaluating device (Z) is provided with an interpolation device for forming interpolation values within one signal period P of the graduation (14).

## Revendications

1. Procédé d'obtention de signaux périodiques exempts d'harmoniques, dans un dispositif de mesure incrémental ou absolu, caractérisé par le fait qu'on détermine la largeur de bande (nombre des fréquences ou ondes) du signal analogique S obtenu lors de la détection d'une graduation (14) d'un corps de mesure (10), qu'on détecte chaque fois, par au moins 2N éléments de détection ($T_1$-$T_{2N}$), la période P (incrément) de la graduation (14), qu'on soumet, pour la détermination des coefficients de Fourier $a_1$, $b_1$ ; $U_a$, $U_b$ de l'onde fondamentale du signal analogique périodique S, les signaux analogiques périodiques ($S_1$-$S_{2N}$) fournis par les éléments de détection ($T_1$-$T_{2N}$) à une analyse de Fourier et que l'on évalue les coefficients de Fourier $a_1$, $b_1$ ; $U_a$, $U_b$ en signaux périodiques exempts d'harmoniques pour former des valeurs de mesure de position.

2. Procédé selon la revendication 1, caractérisé par le fait que, pour l'évaluation numérique, on numérise les signaux analogiques ($S_1$-$S_{2N}$) des éléments de détection ($T_1$-$T_{2N}$) et qu'on détermine, par calcul, les coefficients de Fourier $a_1$, $b_1$ en signaux périodiques exempts d'harmoniques, puis la position de phase $\varphi$ = arc tg $a_1/b_1$ à l'intérieur d'une période P de la graduation (14) à partir des coefficients de Fourier $a_1$, $b_1$.

3. Procédé selon la revendication 1, caractérisé par le fait que, pour l'évaluation analogique, on multiplie par un facteur cos $\pi$ (n−1)/N les signaux analogiques ($S_1$, ..., $S_n$, ..., $S_{2N}$) et qu'on les additionne pour la formation d'un signal analogique $U_a$, qu'on multiplie, par un facteur sin $\pi$ (n−1)/N, les signaux analogiques ($S_1$, ..., $S_n$, ..., $S_{2N}$) et qu'on les additionne pour la formation d'un signal analogique $U_b$ et que l'on détermine la position de phase $\varphi$ = arc tg $U_a/U_b$ à l'intérieur d'une période P de la graduation (14) à partir des signaux analogiques périodiques exempts d'harmoniques $U_a$, $U_b$.

4. Dispositif de mise en œuvre du procédé selon la revendication 1, caractérisé par le fait que, pour la détection de la période P de la graduation (14), il est prévu, dans une unité de détection (12), au moins deux fois autant d'éléments de détection ($T_1$-$T_{2N}$) que la largeur de bande N (nombre des ondes ou fréquences du signal analogique S) en comporte et par le fait que les signaux analogiques périodiques ($S_1$-$S_{2N}$) fournis par les éléments de détection ($T_1$-$T_{2N}$) sont appliqués à un dispositif d'évaluation (U, R; W, Z) pour la détermination des coefficients de Fourier $a_1$, $b_1$ ; $U_a$, $U_b$ de l'onde fondamentale et pour la formation de valeurs de mesure de position à partir des coefficients de Fourier $a_1$, $b_1$ ; $U_a$, $U_b$, lequel dispositif d'évaluation est relié, de son côté, à une unité de commande et/ou d'indication (A).

5. Dispositif selon la revendication 4, caractérisé par le fait que la largeur B des éléments de détection ($T_1$-$T_{2N}$) est inférieure à P/2N et que les éléments de détection ($T_1$-$T_{2N}$) sont disposés à un écartement mutuel P/2N+zP (z=0, 1, 2, ...) dans l'unité de détection (12).

6. Dispositif selon la revendication 4, caractérisé par le fait que la largeur B des éléments de détection ($T_1$-$T_{2N}$) égale au moins une période de graduation P, que chaque élément de détection ($T_1$-$T_{2N}$) comporte alternativement des zones de signalisation active (20) et des zones de signalisation inactive (21) et que les éléments de détection ($T_1$-$T_{2N}$) sont disposés à un écartement mutuel B+zP+P/2N (z=0, 1, 2, ...) dans l'unité de détection (12).

7. Dispositif selon la revendication 4, caractérisé par le fait que le dispositif d'évaluation (U, R) comporte des convertisseurs analogiques/numériques ($U_1$-$U_{2N}$) soumis à l'action des signaux analogiques périodiques ($S_1$-$S_{2N}$) et un calculateur (R) branché en aval desdits convertisseurs.

8. Dispositif selon la revendication 4, caractérisé par le fait que le dispositif d'évaluation (W) pour la détermination des coefficients de Fourier $U_a$, $U_b$ comporte des amplificateurs ($V_1$, ..., $V_n$, ..., $V_{2N}$) qui sont soumis à l'action des signaux analogiques périodiques ($S_1$, ..., $S_n$, ..., $S_{2N}$) et qui sont reliés aux entrées d'amplificateurs différentiels ($D_1$, $D_2$) par des résistances ($R_n'$, $R_n''$).

9. Dispositif selon la revendication 4, caractérisé par le fait que le dispositif d'évaluation (Z) pour la formation de valeurs de mesure de position comporte un discriminateur de direction qui est soumis à l'action des coefficients de Fourier $U_a$, $U_b$ et qui est relié à un compteur/décompteur.

10. Dispositif selon la revendication 4, caractérisé par le fait que le dispositif d'évaluation (Z) comporte un dispositif d'interpolation pour la formation de valeurs d'interpolation à l'intérieur d'une période de signal P de la graduation (14).

FIG.1

FIG.2

FIG. 3a

FIG. 3b

FIG. 4

# FIG.5

# FIG.6

0 106 951

FIG. 7

13